# EUROPÄISCHE PATENTSCHRIFT

(11) **EP 2 912 686 B1**
(45) Veröffentlichungstag und Bekanntmachung des Hinweises auf die Patenterteilung: **21.12.2016**
(21) Anmeldenummer: 13780143.7
(22) Anmeldetag: 23.10.2013
(51) Int. Cl.: H01L 21/768, H01L 21/288, C23C 18/16

(54) **VERFAHREN ZUR ERZEUGUNG VON METALLISIERUNGEN IN SACKLOCH-VIAS**
METHOD FOR THE METALLIZATION OF BLIND VIAS
PROCÉDÉ DE RÉALISATION DE MÉTALLISATIONS DANS DES TROUS D'INTERCONNEXION BORGNES

(30) Priorität: 24.10.2012 DE 102012021144
(43) Veröffentlichungstag der Anmeldung: 02.09.2015
(73) Patentinhaber: Fraunhofer-Gesellschaft zur Förderung der angewandten Forschung e.V., 80686 München (DE)
(72) Erfinder: STOLLE, Thomas, 12555 Berlin (DE); SANDJAJA, Marco, 10555 Berlin (DE)
(74) Vertreter: Pfenning, Meinig & Partner mbB
(86) Internationale Anmeldenummer: PCT/EP2013/072172
(87) Internationale Veröffentlichungsnummer: WO 2014/064153

(56) Entgegenhaltungen:
- WO-A1-92/01088
- JP-A- H02 282 484
- US-A1- 2008 149 487
- SIAU S ET AL: "Processing quality results for electroless/electroplating of high-aspect ratio plated through holes in industrially produced printed circuit boards", MICROELECTRONICS AND RELIABILITY, ELSEVIER SCIENCE LTD, GB, Bd. 45, Nr. 3-4, 1. März 2005 (2005-03-01) , Seiten 675-687, XP027853522, ISSN: 0026-2714 [gefunden am 2005-03-01] in der Anmeldung erwähnt

## Beschreibung

Die Erfindung betrifft ein Verfahren zur Erzeugung von Metallisierungen in Sackloch-Vias, die in einem Substrat eingebracht sind, für den Aufbau von dreidimensionalen mikroelektronischen Schaltkreisen nach dem Oberbegriff des Hauptanspruchs.

Das stromlose Abscheiden von Metallschichten auf Kunststoff- und Halbleiterflächen in mindestens zwei Verfahrensschritten, dem Bekeimen mit einem katalytisch wirksamen Material und dem stromlosen Abscheiden aus einem entsprechenden Metallisierungsbad, ist seit langer Zeit bekannt. Problematisch ist die Tatsache, dass unter normalen Betriebsbedingungen der Bäder sich das Metall bevorzugt an der freien Oberfläche des Substrats, beispielsweise aus Kunststoff, oder des Wafers abscheidet und nur begrenzt in die Tiefe von in das Substrat bzw. den Wafer eingebrachten Vias eindringt. Es treten beim Transport der Badflüssigkeit bzw. deren Bestandteilen in die Tiefe der Vias zunehmend Probleme auf, deren Ursache eine zu geringe Diffusionsgeschwindigkeit der Badkomponenten im Vergleich zur Abscheidegeschwindigkeit ist. Ein weiteres Problem besteht darin, dass sich bei nahezu allen bekannten stromlosen Metallisierungsbädern in einer Nebenreaktion Gase bilden, die in den engen Vias den Flüssigkeitstransport behindern. Im Ergebnis wachsen die Vias an der Oberfläche bzw. im oberen Bereich zu und können nicht weiter gefüllt werden, wobei diese Fehler als "Voids" bezeichnet werden.

Ein bekanntes Verfahren zur Lösung des genannten Problems besteht darin, in einem ersten Schritt das Substrat bzw. den Wafer mit einer dünnen Metallschicht oder einer Kombination von unterschiedlichen Metallen, z.B. Titan/ Wolfram und Kupfer, zu besputtern oder zu bedampfen und in einem zweiten Schritt vorhandene Vias galvanisch mit einem Metall, z.B. Kupfer, zu füllen. Es sind dabei gewisse Badzusätze bekannt, die die Eigenschaft haben, die Cu-Abscheidung in der Tiefe der Vias zu fördern und an der Oberfläche zu behindern. Abgesehen davon, dass der dabei verwendete Vakuumschritt kostenaufwendig ist, können mit einem solchen Verfahren nur begrenzte Via-Tiefen erreicht werden, weil die Sputterschicht an den Wänden mit zunehmender Tiefe immer dünner wird und diese schließlich nicht mehr ausreichend elektrisch leitfähig ist. Außerdem können die verwendeten Barriereschichten in größeren Via-Tiefen nicht in der notwendigen Dicke abgeschieden werden. Das angegebene Verfahren wird vorteilhaft bei Vias mit einem Durchmesser von ≥ 20 µm und einem Aspektverhältnis bis zu ca. 5 eingesetzt. Spezielle Sputtertechniken erreichen zwar noch bessere Aspektverhältnisse, jedoch sind die dafür einsetzbaren Apparaturen entsprechend kostenintensiver.

Bei einem in der Veröffentlichung von Wang, Z., Obata, R. et al., "Bottom-up copper fill with addition of mercapto alkyl carboxylic acid in electroless plating", Electrochimica Acta 51, Seiten 2442-2446, August 2005, beschriebenen Verfahren auf der Basis der stromlosen Metallisierung werden dimensionsmäßig viel kleinere Vias mit einem Durchmesser von > etwa 1 µm und einer Tiefe von < 5 µm zunächst mit einer katalytisch wirkenden Keimschicht versehen, auf der in einem zweiten Schritt nasschemisch stromlos Kupfer abgeschieden werden kann. Durch spezielle Badzusätze kann die Cu-Abscheidung in der Tiefe der Vias gefördert und an der Wafer-Oberfläche behindert werden. Die Vias können verfahrensgemäß vom Boden aufgefüllt werden, jedoch ist der geschilderte Effekt nach Aussage der Autoren nur bei Vias mit den genannten kleinen Dimensionen zu beobachten.

Aus "A Complete Solution for Microvia Metallization" von Verbunt, H., Isik, D. et al., TPCA Show Technical Conference 2007; circuitree.com, Februar 2007, ist bekannt, die Innenwände der Vias, gegebenenfalls zusätzlich zum oben genannten Sputtern, mit einer elektrisch leitfähigen Schicht aus einem anorganischen bzw. organischen Material (Braunstein MnO₂, gleitfähige organische Polymere u. a.) zu belegen und anschließend galvanisch zu füllen. Eine spezielle Variante mit Deaktivierung der Außenfläche der Substrate und Beschichten der Innenfläche der Vias mit sulfoniertem Poly-Dimethyl-diallylammoniumchlorid wird in "High Speed Through Silicon Via Filling by Copper Electrodeposition" von Kondo, K., Suzuki, Y. et al., Electrochemical and Solid-State Letters, 2010, Vol. 13(5), Seiten D26-D28, vorgeschlagen. Die elektrische Leitfähigkeit solcher organischer Schichten ist jedoch deutlich geringer als die von metallischen Schichten, wodurch beim galvanischen Füllen von Vias mit hohem Aspektverhältnis technische Probleme auftreten.

Aus der US 2010/0003808 A1 ist ein Verfahren bekannt, bei dem die Oberfläche von Si-Substraten mit Durchgangsvias mit dünnen Schichten aus organischem Material versehen wird, die sowohl als Migrationsbarriere für das Metall der Leiterbahnen als auch als Haftschicht für die Bekeimung einer nachfolgenden Flash-Metallisierung dienen kann. Ein anderes Verfahren zur Erreichung einer elektrischen Leitfähigkeit auf nichtleitenden Oberflächen wird in der Veröffentlichung "Polyaniline on the Metallic Side of the Insulatorto-Metal Transition due to Dispersion: the Basis for successful Nano-Technology and Industrial Applications of Organic Metals" von Wessling, B., Synthetic Metals 102 (1999), Seiten 1396-1399, vorgeschlagen. Hier werden aus einer Dispersion nicht lösliche Polyanilin-Derivate auf die jeweilige Oberfläche aufgetragen. Unabhängig von der Art der gewählten Bekeimungsmethode bleibt jedoch bei beiden vorgenannten Verfahren das Problem bestehen, dass bei größerem Aspektverhältnis der im Vergleich zum Via-Durchmesser große Diffusionsweg der Bestandteile des Metallisierungsbades bis in die Tiefe der Vias zu bevorzugter Abscheidung im oberen Bereich der Vias führt.

Bei der Herstellung von Leiterplatten durch stromlose Verkupferung ist bekannt, dass die an der Oberfläche anhaftenden Gasblasen, welche die gleichmäßige Metallisierung beeinträchtigen, durch mechanische Erschütterung der Plattenträger abgelöst werden können. Derartige mechanische Stöße werden auch bei der Metallisierung von gebohrten Vias eingesetzt, wie in "Processing quality results for electroless/electroplating of high-aspect ratio plated through holes in industrially produced printed circuit boards", Siau, S., De Baets, J. et al., Microelectronics Reliability 45 (2005), Seiten 675-687, beschrieben. Es handelt sich hierbei aber um durchgehende Vias, bei denen die Gasblasen durch die Strömung der Elektrolytflüssigkeit relativ zur Platten- bzw. Viaoberfläche mitgerissen werden.

Der Erfindung liegt die Aufgabe zugrunde, ein nasschemisches Verfahren zur Erzeugung von tiefen Flash-Metallisierungen in engen Sackloch-Vias, die in einem Substrat, z. B. in einem Wafer, eingebracht sind, für den Aufbau von dreidimensionalen mikroelektronischen Schaltkreisen zu schaffen, bei dem der Flüssigkeitstransport des Elektrolyts des Metallisierungsbades in die Sackloch-Vias verbessert wird und die bei der Metallabscheidung als Nebenreaktion entwickelten Gase aus den Sackloch-Vias entfernt werden.

Diese Aufgabe wird erfindungsgemäß durch die Merkmale des Hauptanspruchs gelöst.

Durch die in den Unteransprüchen angegebenen Maßnahmen sind vorteilhafte Weiterbildungen und Verbesserungen möglich.

Erfindungsgemäß werden bei dem Verfahren zur Erzeugung von Metallisierungen in Sackloch-Vias, die in ein Substrat eingebracht sind, das Substrat und die Sackloch-Vias, das selbst katalytisch aktiv ist oder das mit einem katalytisch wirkenden Material bekeimt wird, zumindest teilweise in einem Meta-Ilisierungsbad durch stromlose Abscheidung metallisiert. Dadurch, dass auf das Metallisierungsbad mit dem Substrat mechanische Kraftstöße derart aufgebracht werden, dass die jeweils erzeugte Beschleunigung in Richtung der Öffnung der Sackloch-Vias zur Verbesserung des Flüssigkeitstransports in den Sackloch-Vias und zum Austreiben von Gasblasen wirkt, wird die Badflüssigkeit bzw. der Elektrolyt des Metallisierungsbades bis in die Tiefe der Sackloch-Vias transportiert, wobei die bei der Metallabscheidung als Nebenprodukt auftretenden Gasblasen als indirektes Transportmittel für die Badflüssigkeit verwendet werden. Die mechanischen Kraftstöße bzw. Stoßimpulse werden in der Badflüssigkeit weitergeleitet und wirken auf das im Inneren der Vias befindliche Gasblasen-Elektrolyt-Gemisch dahingehend, dass die Gasblasen aus den Vias hinausbefördert und gleichzeitig entsprechend frischer Elektrolyt in die Vias hineinbefördert wird. Die normalerweise bei der stromlosen Metallisierung als störend empfundene Gasentwicklung wird somit beim erfindungsgemäßen Verfahren in den Vorteil verwandelt, dass entsprechend einem Mikropumpen-Prinzip die Badflüssigkeit bzw. der Elektrolyt schnell in die Vias gelangt, wodurch die Diffusionsgeschwindigkeit der Badkomponenten erhöht wird. Bei dem erfindungsgemäßen Verfahren geschieht die Kraftübertragung über eine sich zwischen Boden des Metallisierungsbades und Sustrat befindenden Flüssigkeitslamelle oder -schicht, wodurch die Kräfte gleichmäßig und flächenmäßig auf das Substrat verteilt werden. Daher treten keine Biegekräfte an dem Substrat auf, wodurch die Gefahr des Zerbrechens oder Beschädigung des Substrats selbst bei spröden Materialien vermieden wird.

Das Substrat besteht üblicherweise aus einem Halbleitermaterial, z. B. Silizium, es kann jedoch auch gegebenenfalls ein anderes, insbesondere sprödes Material in Frage kommen, z. B. Glas oder Keramik.

In einem bevorzugten Ausführungsbeispiel werden Kraftstöße asymmetrisch aufgebracht, d.h. es werden die Stärke der Kraftstöße und die Stoßzeiten so gewählt, dass sie zu einer Beschleunigung der Badflüssigkeit und des Substrats bei der stoßbedingten Aufwärtsbewegung von mindestens 10 m/sec², bevorzugt 15 - 50 m/sec² bei einer Beschleunigungsdauer von maximal 1/100 sec führen, wobei die Abwärtsbewegung zurück in die Ausgangslage maximal bis zur Beschleunigung beim freien Fall beschleunigt wird.

Bei den Metallisierungsverfahren wird üblicherweise die Oberfläche des Substrats bzw. Wafers, also auch die Via-Innenwände, passiviert und mit einer Barriereschicht gegen Diffusion des Metalls, üblicherweise Kupfer, in das Substratmaterial versehen. Gegebenenfalls reichen einfach zu erzeugende Oxid- oder Nitridschichten nicht aus, so dass eine zusätzliche Schicht aus z. B. Ni-B- oder Co-B-Legierungen eingebracht werden muss. Bei dem erfindungsgemäßen nasschemischen Verfahren werden somit die Innenwände der SacklochVias mit einer oder mehreren solchen dünnen Metallschicht(en), wie ausgeführt bestehend aus Kupfer oder den genannten Barrieremetallen, bedeckt, und in einem nicht näher ausgeführten Folgeschritt können die Sackloch-Vias dann galvanisch gefüllt werden. Die Dimensionen der Sackloch-Vias, die allgemein mit "tief" und "eng" bezeichnet sind, liegen im Bereich bezüglich des Via-Durchmessers von < 20 µm bis > 3 µm und einer Tiefe von
> 5 µm bis < 150 µm, wobei das Aspektverhältnis AR (Quotient Via-Tiefe durch Via-Durchmesser) > 5 bis vorzugsweise 10 beträgt.

Besonders bevorzugt werden die Kraftstöße in Richtung der Achsen der Sackloch-Vias aufgebracht, wodurch das Austreiben der Gasblasen am effizientesten durchgeführt wird.

Vorzugsweise wird das Substrat in einem das Metallisierungsbad aufnehmenden Behälter ohne Verbindung zu Behälterwänden angeordnet, wobei die Öffnungen der Sackloch-Vias zum Behälterboden abgewandt liegen, und die Kraftstöße werden dann auf den Behälterboden aufgebracht.

Im bevorzugten Ausführungsbeispiel ist das Substrat in einem das Metallisierungsbad aufnehmenden Behälter freiliegend im Wesentlichen parallel zum Behälterboden angeordnet, wobei zwischen Substrat und Behälterboden eine Flüssigkeitslamelle oder -schicht zur Kraftübertragung ausgebildet ist. Die Stöße werden somit über die Flüssigkeit auf das Substrat geleitet. Dabei wirkt der Impuls bzw. der Kraftstoß parallel zu der Richtung der Vias und in Richtung ihrer Öffnung.

In einem Ausführungsbeispiel kann eine Kraftverteilungsplatte unterhalb des Behälterbodens vorgesehen werden, die vorzugsweise vom Behälterboden mechanisch getrennt ist und auf die die Kraftstöße aufgebracht werden. Durch eine solche Platte kann der aufgebrachte Kraftimpuls flächenmäßig verteilt werden und gleichmäßiger in die Badflüssigkeit geleitet werden.

Erfindungsgemäß können die Stoßimpulse bzw. Kraftstöße durch unterschiedliche technische Maßnahmen realisiert werden, wie beispielsweise mittels eines Hammerwerkes, einer Rüttelmaschine oder mittels einer Mehrzahl von Piezoelementen, die als Impulsgeber verwendet werden und sich gleichmäßig über das Innere des Bades verteilen.

In einem bevorzugten Ausführungsbeispiel werden die Kraftstöße als elastische Stöße auf das Metallisierungsbad aufgebracht.

Bei Verwendung des Hammerwerks kann zur Erzielung der elastischen Kraftstöße zwischen Hammer und Behälter oder gegebenenfalls zwischen Hammer und Kraftverteilungsplatte und/oder elastisches Material angeordnet sein. Dadurch kann die Beschleunigung optimiert werden, wobei zusätzlich der Elastizitätsmodul des elastischen Materials mit in Betracht gezogen werden kann.

In einem erfindungsgemäßen Ausführungsbeispiel können die Kraftstöße kontinuierlich oder in gruppierter Aufeinanderfolge von kontinuierlichen Stößen ausgeführt werden, wobei 1 bis 10 Stöße pro 10 Sekunden aufgebracht werden und die Intervalle zwischen den Gruppen der kontinuierlichen Kraftstöße mindestens das 10fache der Intervalle zwischen den kontinuierlichen Kraftstößen betragen. Durch die Berücksichtigung der Intervalle zwischen den Kraftstößen sowie zwischen den Gruppen der Kraftstöße kann die Größe der gebildeten Gasblasen gesteuert werden und somit der Transport der Gasblasen optimiert werden. Durch die Wahl der Stärke und der Zeitdauer des Kraftstoßes wird die notwendige Beschleunigung beim Stoßimpuls auf die Gasblasen in den Vias ausgeübt, so dass diese aufgrund ihrer geringeren Trägheit in Bezug auf die Badflüssigkeit aus den Vias getrieben werden, wobei gleichzeitig Badflüssigkeit in die Vias gesogen wird. Weiterhin wird sichergestellt, dass die Rückführung in die Ausgangslage des Behälters mit einer kleineren Beschleunigung vorgenommen wird, damit die Gasblasen nicht wieder zurücktransportiert werden.

Vorzugsweise liegen der Durchmesser der Sackloch-Vias zwischen 3 µm und 20 µm und die Tiefe zwischen 10 µm und 150 µm, wobei das Aspektverhältnis größer als 5, vorzugsweise größer als 8 ist.

In besonders vorteilhafter Weise werden bei dem erfindungsgemäßen Verfahren für die stromlose Metallisierung Cu- oder Co-Bäder, einschließlich üblicher Legierungszusätze wie B und W, verwendet, wobei jedoch alle solchen Bäder verwendet werden können, bei denen sich bei der Metallabscheidung als Nebenreaktion Gase entwickeln.

In einer Ausführungsform können mehrere Substrate übereinander angeordnet werden, wobei sie dann durch eine flexible Halterung gehalten werden, die beispielsweise als ein leichtes Netz aus chemisch resistentem Kunststoff ausgebildet ist, die die Substrate, z.B. Wafer wie ein Schlauch umspannt. Auch bei dieser Ausführungsform sind die Substrate mit Halterung freiliegend in der Badflüssigkeit angeordnet. Die Substrate können auch schräg übereinander gestapelt werden, wodurch die Ableitung von Gasblasen verbessert wird.

Das erfindungsgemäße Verfahren kann je nach Art des Bades mit anderen bekannten Maßnahmen kombiniert werden, die das Verhältnis von Diffusion der Metallionen zu deren Abscheidung im Inneren der Vias verbessern, z.B. Abscheidung bei niedriger Temperatur, wie Raumtemperatur, Abscheidung bei einem pH-Wert, der die Abscheidegeschwindigkeit verringert, Abscheidung mit erhöhter Stabilisatorkonzentration und dergleichen. Die Wirkung der Stöße kann auch dadurch verbessert werden, dass die Metallisierung zeitweilig zur Vergrößerung der Gasblasen unter Vakuum ausgeführt wird, ohne dabei den Siedepunkt der Badflüssigkeit zu erreichen. Die vollständige Benetzung der Via-Innenwand kann auch dadurch verbessert und erzwungen werden, dass die jeweilige Probe vor der Einwirkung der Badflüssigkeit evakuiert wird, die Flüssigkeit anschließend unter Vakuum mit der Probe in Berührung gebracht und schließlich die von Badflüssigkeit umgebene Probe belüftet wird.

In einem bevorzugten Ausführungsbeispiel können beim Bekeimen des Substrats, das in eine in einem Gefäß aufgenommene Bekeimungsflüssigkeit eingetaucht wird, auf das Gefäß gleichfalls Kraftstöße derart aufgebracht werden, dass sie in Richtung der Öffnung der Vias wirken. Daher können im Fall festsitzender Luftblasen in den Vias beim Eintauchen der trockenen Wafer bzw. Substrate in die Bekeimungsflüssigkeit die Gasblasen ausgetrieben werden, so dass die Gefahr einer mangelhaften Benetzung der Via-Innenfläche, was zum Ausfall der Bekeimung an diesen Stellen führen würde, verhindert wird.

im Folgenden werden Ausführungsbeispiele des erfindungsgemäßen Verfahrens anhand der beigefügten Zeichnung näher erläutert. Es zeigt
- Fig. 1: eine schematische Ansicht einer bei der Erfindung verwendeten Anordnung zum stromlosen Abscheiden von Metallisierungen,
- Fig. 2: einen Ausschnitt eines Teils eines Substrats, das bei dem erfindungsgemäßen Verfahren metallisiert werden soll,
- Fig. 3: ein Diagramm des bei der Metallisierung erreichten Aspektverhältnisses in Abhängigkeit vom Sackloch-Via-Durchmesser für eine gemäß der Erfindung behandelte Probe und eine Vergleichsprobe, und
- Fig. 4: eine schematische Ansicht einer weiteren bei der Erfindung verwendeten Anordnung zum stromlosen Abscheiden von Metallisierungen.

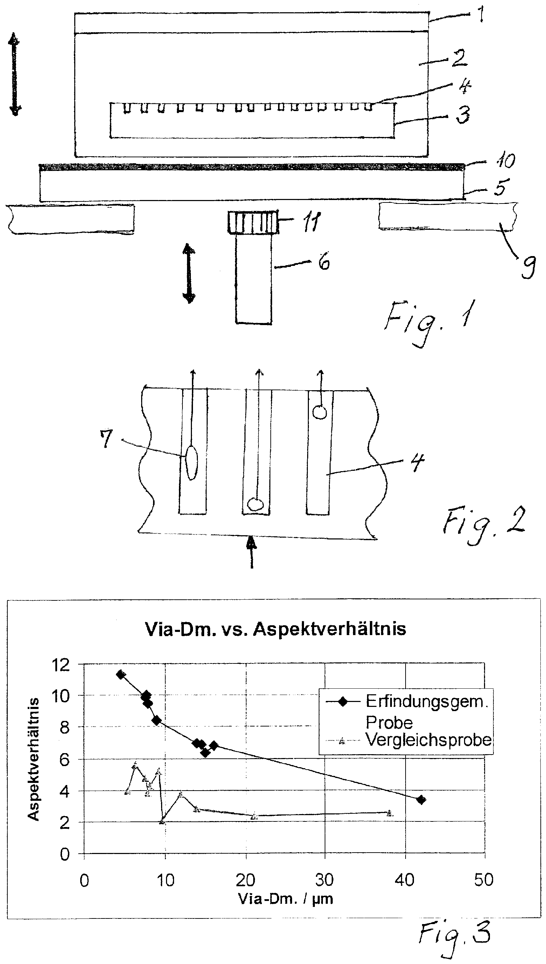

In Figur 1 ist eine Anordnung für eine stromlose Flash-Metallisierung dargestellt, die einen Behälter 1 aufweist, in dem eine Badflüssigkeit, beispielsweise ein Cu-Bad 2, aufgenommen ist. In der Badflüssigkeit ist ein flächenartiges Probematerial, z. B. ein Si-Wafer 3 mit Sackloch-Vias 4, eingelegt. Der Wafer 3 liegt frei in der Badflüssigkeit und hat keine Verbindung zum Behälter, wobei zwischen Badflüssigkeit und Behälterboden eine Flüssigkeitslamelle bzw. eine Flüssigkeitsschicht, wie in Fig.1 zu erkennen ist, vorhanden ist. Der Behälter 1 befindet sich auf einem Tisch 9, wobei vorzugsweise auf dem Tisch 9 eine Platte, z.B. eine Metallplatte 5 angeordnet ist, auf der der Behälter 1 steht. Unterhalb des Behälters befindet sich ein Hammerwerk 6, das mechanische Kraftstöße bzw. Stoßimpulse von unten auf die Platte 5 und damit auf den Behälter und die darin befindliche Badflüssigkeit 2 mit dem Wafer 3 ausüben kann. Vorzugsweise sind Behälter 1, Platte 5, die als Kraftverteilungsplatte dient und Tisch 9 voneinander mechanisch entkoppelt. Damit elastische Stöße erzeugt werden, kann zwischen Platte 5 und Behälter 1 eine elastische Schicht 10 vorgesehen werden.

Auch kann der Hammer 6 des Hammerwerkes mit einer elastischen Auflage 1 versehen sein.

Die elastische Schicht 10, die auch ein elastisches Tuch sein kann, und die elastische Auflage können beispielsweise aus Gummi oder aus einem anderen elastischen und gegebenenfalls komprimierbaren Material bestehen.

Das Hammerwerk 6 wird derart angesteuert, dass ein kurzer Kraftstoß, z. B. für eine Zeitdauer von maximal 1/100 Sekunden, auf die Metallplatte 5 aufgebracht wird. Dann wird der Hammer 6 wieder zurückgezogen, und nach einem kurzen Intervall von 1 bis 10 Sekunden wird der Kraftstoß erneut durchgeführt. Der Impuls des Kraftstoßes führt dazu, dass der Behälter 1 zwischen ca. 1 mm und maximal 5 cm, bevorzugt um bis 1 cm nach oben geschleudert wird, was zu den oben angegebenen Beschleunigungen führt. Es können beispielsweise 1 bis 10 Stöße pro 10 Sekunden durchgeführt werden.

Der jeweilige Stoßimpuls wird in die Badflüssigkeit 2 und somit in den Wafer weitergeleitet und wirkt auf das im Inneren der Vias befindliche Gasblasen-Elektrolyt-Gemisch entsprechend Figur **2** dahingehend, dass die Gasblasen aus den Vias 4 herausbefördert werden und gleichzeitig Elektrolyt aus der Badflüssigkeit 2 in die Vias 4 hineinbefördert wird. Die Gasblasen 7 werden durch die vom Kraftstoß hervorgerufene Beschleunigung und aufgrund der unterschiedlichen Trägheit des Elektrolyts und der Gasblasen 7 in den Vias durch die Öffnungen der Vias 4 in die Badflüssigkeit 2 bewegt. Vorzugsweise hat der Wafer im Bad, wie dargestellt, eine waagerechte Lage, und die Sackloch-Vias sind senkrecht in den Wafer 3 eingebracht, wodurch sich praktische Vorteile im Aufbau ergeben. Grundsätzlich können jedoch auch andere Anordnungen vorgesehen werden, wobei die aufgebrachten Kraftstöße zumindest eine Richtungskomponente in Richtung der Achse der Vias 4 haben sollten.

Die Vias 4 sind im Ausführungsbeispiel rund, sie können jedoch auch einen ovalen Querschnitt haben. Der jeweilig aufgebrachte Kraftstoß sollte gleichmäßig über die Waferfläche verteilt werden; dazu dient beispielsweise die Metallplatte 5 und die große Fläche des Hammerwerkes 6.

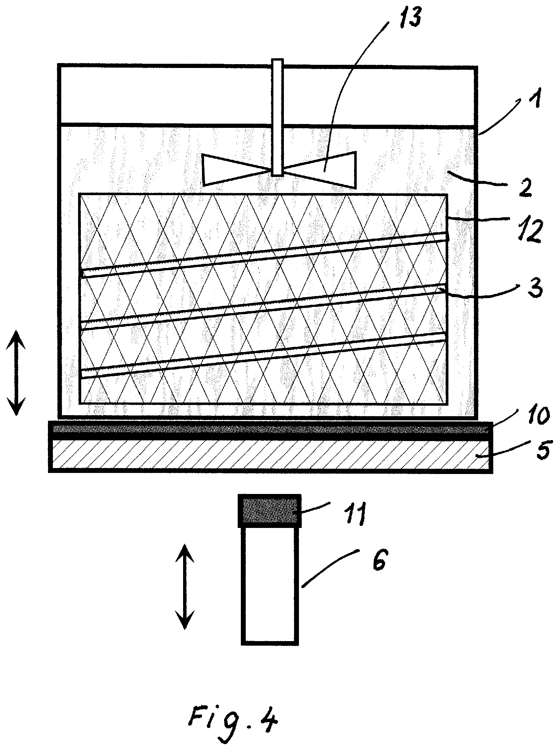

Für den Fall, dass mehrere Wafer 3 gleichzeitig im Bad metallisiert werden sollen (siehe Figur 4), kann eine Halterungsvorrichtung 12 aus einem elastischen Material eingesetzt werden, die die Wafer übereinander in einem solchen Abstand zueinander fixiert, dass ein genügender Flüssigkeitsaustausch zwischen den Wafern 3 erfolgen kann. Dazu kann zusätzlich ein Rührwerk 13 vorgesehen werden. Die Halterungsvorrichtung 12 dient nicht zur Kraftübertragung der Stöße durch das Hammerwerk 6. Sie muss im Gegenteil so konstruiert sein, dass die vom Hammerwerk 6 auf das Bad 2 bzw. die Badflüssigkeit ausgeübten Impulse nicht gehemmt werden. Dies ist z.B. durch ein leichtes Netz aus chemisch resistentem Kunststoff möglich, das die Wafer 3 wie ein Schlauch umspannt.

Zur Ableitung von Gasblasen, welche sich gegebenenfalls an der unteren Seite des jeweils oberhalb angeordneten Wafers 3 ansammeln und die Wirkung der Stoßimpulse durch ihre Elastizität verändern, kann es in diesem Falle nützlich sein, die Wafer 3 in einem Winkel von ca. 5 - 15 Grad schräg zur Stoßrichtung des Hammerwerkes 6 anzuordnen.

Im Folgenden soll die Erfindung anhand von Beispielen weiter erläutert werden, wobei die jeweils angegebenen Parameter und Größen sich nicht auf das jeweilige Beispiel begrenzen, sondern für alle Ausführungsformen verwendet werden können.
Beispiel 1: Ein Si-Wafer mit Sackloch-Vias der Dimensionen Durchmesser 3 - 20 µm, Tiefe 50 - 100 µm (AR 5 ->10, je nach Via-Durchmesser) und oxidierter Oberfläche (Dicke der SiO₂-Schicht ca. 200 nm) wird zur Bekeimung in eine Lösung von 60 mg Palladiumacetat (PdAc) in 100 ml Aceton mit den Vias nach oben in eine flache Schale/Wanne eingelegt. Nach einer Einwirkungszeit von ca. einer Minute wird der Wafer aus dem Gefäß entnommen, zum Ablaufen der Flüssigkeit wenige Sekunden senkrecht gestellt, danach waagerecht auf eine saugfähige Unterlage gelegt und die überstehende Flüssigkeit mit einem Gummiwischer abgestreift. Anschließend wird der Wafer ca. 10-60 Minuten bei Raumtemperatur an der Luft getrocknet und schließlich in einem Trockenschrank bei 220°C ca. 15 Minuten getempert.
   Nach dem Abkühlen wird der Wafer waagerecht mit Sackloch-Vias nach oben liegend in ein bei Raumtemperatur betriebenes Bad der Firma Rohm & Haas (Circuposit 3350, in flacher Schale oder Wanne betrieben) eingelegt. Zur Verringerung der O₂-Konzentration im Bad wird dieses mit einer zusätzlichen aktiven Abscheidungsfläche für Cu (z. B. einem Cu-Blech) versehen und gerührt. Erfindungsgemäß werden während der Metallisierungszeit Hammerschläge von unten auf den Boden des Reaktionsgefäßes ausgeführt. Der Boden des Gefäßes muss hierbei eine ausreichende Steifheit aufweisen, um den Impuls zumindest auf die Waferfläche gleichmäßig zu verteilen. Die Impulsstärke der Schläge ist von der Masse des Reaktionsgefäßes abhängig und ist so bemesen, dass das Gefäß im zeitlichen Abstand von ca. 3 Sekunden ca. 0,5 - 2 mm nach oben geschleudert wird. Anschließend fällt der Behälter auf den sich absenkenden Hammer zurück. Die Metallisierungszeit liegt bei einer Stunde.
   Nach der stromlosen Metallisierung wird der Wafer mehrfach mit Wasser gespült und getrocknet.
   An den glatten Außenflächen des Wafers ist nur bei enger Belegung der Fläche mit Vias eine durchgehende Metallisierung vorhanden; in diesem Fall können die Vias direkt nach einem nicht erfindungsgemäßen Verfahren galvanisch gefüllt werden. Bei größerem Pitch ist die elektrische Verbindung zwischen den Vias unterbrochen; in diesem Fall muss eine elektrische Verbindung z. B. durch eine bekannte Sputter-Methode erzeugt werden.
   Zur Bewertung der Methode wurden die so erhaltenen Proben zunächst nach einer nicht erfindungsgemäßen Methode mit TiW/Cu besputtert und anschließend in einem Cu-Bad galvanisch gefüllt. Es zeigt sich, dass unter Verwendung der erfindungsgemäßen Methode bei runden Vias mit einem Durchmesser von 3 und 5 µm ein Aspektverhältnis AR von > 10 bzw. 8,5 erreicht werden kann.
   Eine Vergleichsprobe ohne Einsatz der erfindungsgemäßen Methode, aber sonst gleichartiger Behandlung, erreicht nur ein AR von bestenfalls 5.
Beispiel 2: Wafer-Proben mit Sackloch-Vias der Durchmesser 3 - 40 µm und Tiefe 80 - 110 µm (abhängig vom Durchmesser) werden nicht erfindungsgemäß zunächst mit O₂-Plasma behandelt, dann mit Chemikalien der Firma Cookson Electronics / Enthone (bestehend aus Primer-, Aktivator- und Accelerator-Lösung) bekeimt und mit dem stromlosen Cu-Bad Enplate Cu LDS 100 dieser Firma bei Raumtemperatur metallisiert. Die Primer-Schicht wird hier zur Fixierung nur bei 120°C getempert, die anderen Behandlungen erfolgen bei Raumtemperatur mit Zwischenspülung in Wasser ohne Zwischentrocknung. Die Metallisierungszeit beträgt eine Stunde unter Rührung und mit zusätzlich eingeführtem Cu-Blech. Vom Boden des Reaktionsgefäßes werden durch ein Hammerwerk Schläge im Rhythmus von ca. 3 Schlägen in 10 Sekunden wie im Beispiel 1 ausgeführt.
   Zum Vergleich wird ein gleichartiger Versuch ohne Einsatz des Hammerwerkes durchgeführt.
   Die Auswertung erfolgt nach Anfertigung von Querschliffen durch Vermessung der erreichten Metallisierungstiefe in den Vias. Die Ergebnisse sind in Figur 3 dargestellt; sie zeigt das erreichte Aspektverhältnis in Abhängigkeit vom Via-Durchmesser. Es ist zu erkennen, dass bei der erfindungsgemäßen Probe eine gleichmäßigere Via-Metallisierung bei besserem Aspektverhältnis vorliegt.
   Wie aus Fig. 3 zu erkennen ist, nimmt das Aspektverhältnis, das angibt, wie weit die Sacklöcher metallisiert wurden, bei der erfindungsgemäßen Probe für einen Durchmesser zwischen etwa 5 und etwa 15 µm von etwa 11,5 bis etwa 7 gleichmäßig ab, während die Vergleichsprobe in diesem Durchmesserbereich mehrere Sprünge zwischen einem Aspektverhältnis von 4 und 6 durchführt und sogar bis 2 abfällt.
Beispiel 3: Der Versuch von Beispiel 1 wird mit den Veränderungen wiederholt, dass die Bekeimung wie in Beispiel 2 und die Flash-Metallisierung mit einem bekannten Co-Bad durchgeführt wird. Die Badzusammensetzung und Reaktionsbedingungen sind: CoCl₂*6H₂O: 4,8 g; H₂WO₄: 1,54 g; Zitronensäure: 11,62 g; DMAB: 0,76 g; H₂O: 117,3 g; TMAH (25%ig): 80,4 g ; pH: 9,34; Reaktionszeit 30 Minuten bei 70°C unter mechanischer Rührung. Bei erfindungsgemäßer Ausführung werden wie in Beispiel 1 und 2 Hammerschläge auf den Boden des Reaktionsgefäßes ausgeübt (5 mm angehoben); zum Vergleich werden unter sonst gleichen Bedingungen keine Hammerschläge ausgeführt.

Die Auswertung erfolgt wie im Beispiel 2 nach Anfertigung von Querschliffen durch Vermessen der in den Vias erreichten Metallisierungstiefe, wobei sich der metallische Glanz des Co von dem der nicht beschichteten Innenwand wegen der Oxidschicht farblich unterscheiden lässt.

Es zeigt sich, dass unter Verwendung der erfindungsgemäßen Methode bei runden Vias mit einem Durchmesser von 3 und 5 µm eine AR von ca. 10 bzw. 8,5 erreicht werden kann.

Eine Vergleichsprobe ohne Einsatz des Hammerwerkes erreichte bei sonst gleichartiger Behandlung nur eine AR von bestenfalls 5.

## Patentansprüche

1. Verfahren zur Erzeugung von Metallisierungen in Sackloch-Vias, die in einem insbesondere aus einem spröden Material bestehenden Substrat für den Aufbau von dreidimensionalen mikroelektronischen Schaltkreisen eingebracht sind, bei dem das Substrat mit den Sackloch-Vias entweder selbst katalytisch aktiv ist oder mit einem katalytisch wirkenden Material bekeimt wird und danach in einem eine Badflüssigkeit enthaltenden Metallisierungsbad durch stromlose Abscheidung zumindest teilweise metallisiert wird,
**dadurch gekennzeichnet, dass**
auf das Metallisierungsbad mit dem Substrat mechanische Kraftstöße derart aufgebracht werden, dass die dadurch jeweils erzeugte Beschleunigung in Richtung der Öffnung der Sackloch-Vias wirkt und zur Verbesserung des Flüssigkeitstransports in den Sackloch-Vias sowie zum Austreiben von Gasblasen führt.

2. Verfahren nach Anspruch 1, **dadurch gekennzeichnet, dass** die Kraftstöße derart aufgebracht werden, dass sie zu einer Beschleunigung der Badflüssigkeit und des Substrates in einer stoßbedingten Aufwärtsbewegung führen, wobei die Beschleunigung mindestens 10 m/sec², bevorzugt 15 - 50 m/sec² bei einer Beschleunigungsdauer von maximal 1/100 sec beträgt und wobei die Abwärtsbewegung zurück in die Ausgangslage dagegen maximal bis zur Beschleunigung beim freien Fall beschleunigt wird.

3. Verfahren nach Anspruch 1 oder Anspruch 2, **dadurch gekennzeichnet, dass** die Kraftstöße kontinuierlich oder in gruppierter Aufeinanderfolge von kontinuierlichen Stößen ausgeführt werden, wobei 1 bis 10 Stöße pro 10 Sekunden aufgebracht werden und die Intervalle zwischen den Gruppen der kontinuierlichen Kraftstößen mindestens das 10fache der Intervalle zwischen den kontinuierlichen Kraftstößen betragen.

4. Verfahren nach einem der Ansprüche 1 bis 3, **dadurch gekennzeichnet, dass** die Kraftstöße als elastische Stöße auf das Metallisierungsbad aufgebracht werden.

5. Verfahren nach einem der Ansprüche 1 bis 4, **dadurch gekennzeichnet, dass** die Kraftstöße in Richtung der Achsen der Sackloch-Vias aufgebracht werden.

6. Verfahren nach einem der Ansprüche 1 bis 5, **dadurch gekennzeichnet, dass** das Substrat in einem das Metallisierungsbad aufnehmenden Behälter ohne Verbindung zu Behälterwänden angeordnet wird, wobei die Öffnungen der Sackloch-Vias abgewandt zum Behälterboden liegen und dass die Kraftstöße auf den Behälterboden aufgebracht werden.

7. Verfahren nach Anspruch 6, **dadurch gekennzeichnet, dass** die Kraftstöße über eine unterhalb des Behälterbodens angeordneten Kraftverteilungsplatte zur flächenmäßigen Verteilung der Kraft auf das Metallisierungsbad aufgebracht werden.

8. Verfahren nach einem der Ansprüche 1 bis 7, **dadurch gekennzeichnet, dass** das Substrat in einem das Metallisierungsbad aufnehmenden Behälter freiliegend im Wesentlichen parallel zum Behälterboden angeordnet ist, wobei zwischen Substrat und Behälterboden eine Flüssigkeitslamelle oder -schicht zur Kraftübertragung ausgebildet ist

9. Verfahren nach einem der Ansprüche 1 bis 8, **dadurch gekennzeichnet, dass** die Kraftstöße mittels eines Hammerwerkes oder mittels einer Mehrzahl von Impulsgebern, wie Piezoelementen, aufgebracht werden.

10. Verfahren nach Anspruch 9, **dadurch gekennzeichnet, dass** bei Verwendung eines Hammerwerkes zwischen Hammer und Behälter oder ggf. zwischen Hammer und Kraftverteilungsplatte und/oder zwischen Kraftverteilungsplatte und Behälter elastisches Material zur Optimierung der Beschleunigung und der Dauer der Beschleunigung angeordnet ist.

11. Verfahren nach einem der Ansprüche 1 bis 10, **dadurch gekennzeichnet, dass** der Durchmesser der Sackloch-Vias zwischen 3 µm und 20 µm und die Tiefe zwischen 10 µm und 150 µm liegen, wobei das Aspektverhältnis größer als 5, vorzugsweise größer als 8 ist.

12. Verfahren nach einem der Ansprüche 1 bis 11, **dadurch gekennzeichnet, dass** für die stromlose Metallisierung Cu- oder Co-Bäder, einschließlich üblicher Legierungszusätze wie B und W, verwendet werden.

13. Verfahren nach einem der Ansprüche 1 bis 8, **dadurch gekennzeichnet, dass** beim Bekeimen des Substrats, das in eine in einem Gefäß aufgenommene Bekeimungsflüssigkeit eingetaucht wird, auf das Gefäß gleichfalls Kraftstöße derart aufgebracht werden, dass sie in Richtung der Öffnung der Sackloch-Vias wirken.

14. Verfahren nach einem der vorhergehenden Ansprüche mit Ausnahme des Anspruchs 8, **dadurch gekennzeichnet, dass** mehrere Substrate übereinander angeordnet werden, wobei die Substrate durch eine flexible Halterung, vorzugsweise ein schlauchartiges Netz, gehalten werden.

15. Verfahren nach Anspruch 14 ohne den Rückbezug auf Anspruch 5, **dadurch gekennzeichnet, dass** die Substrate schräg in Bezug auf einen Behälterboden eines das Metallisierungsbad aufnehmenden Behälters übereinander angeordnet sind.

## Claims

1. A method for producing metallisations in blind vias incorporated in a substrate which in particular consists of a brittle material, for the construction of three-dimensional microelectronic circuits, with which the substrate with the blind vias either itself is catalytically active or is seeded with a catalytically acting material, and subsequently is at least partly metallised in a metallisation bath comprising a bath fluid, by way of electroless plating,
**characterised in that**
mechanical force impacts are exerted upon the metallisation bath with the substrate, in a manner such that the acceleration produced in each case by way of this acts in the direction of the opening of the blind vias and leads to an improvement of the fluid transport in the blind vias, as well as to the expulsion of gas bubbles.

2. A method according to claim 1, **characterised in that** the force impacts are applied in a manner such that they lead to an acceleration of the bath fluid and of the substrate in an upwards movement due to the impact, wherein the acceleration is at least 10 m/sec², preferably 15 - 50 m/sec², with an acceleration duration of maximal 1/100 sec, and wherein the downwards movement back into the initial position in contrast is accelerated to the acceleration at freefall.

3. A method according to claim 1 or 2, **characterised in that** the force impacts are carried out in a continuous manner or in a grouped succession of continuous impacts, wherein 1 to 10 impacts are applied per 10 seconds and the intervals between the groups of continuous force impacts are at least tenfold the intervals between the continuous force impacts.

4. A method according to one of the claims 1 to 3, **characterised in that** the force impacts are applied upon the metallisation bath as elastic impacts.

5. A method according to one of the claims 1 to 4, **characterised in that** the force impacts are applied in the direction of the axes of the blind vias.

6. A method according to one of the claims 1 to 5, **characterised in that** the substrate is arranged in a container receiving the metallisation bath, without a connection to the container walls, wherein the openings of the blind vias lie away from the container base and that the force impacts are applied onto the container base.

7. A method according to claim 6, **characterised in that** the force impacts are applied via a force distribution plate which is arranged below the container base and which is for the surfaced distribution of the force onto the metallisation bath.

8. A method according to one of the claims 1 to 7, **characterised in that** the substrate is arranged in a container receiving the metallisation bath, in an exposed manner and essentially parallel to the container base, wherein a fluid lamella or fluid layer for force transmission is formed between the substrate and the container base.

9. A method according to one of the claims 1 to 8, **characterised in that** the force impacts are applied by way of a hammer mechanism or by way of a plurality of impulse generators such as piezoelements.

10. A method according to claim 9, **characterised in that** with the use of a hammer mechanism, elastic material for optimising the acceleration and the duration of the acceleration is arranged between the hammer and container or, as the case may be, between the hammer and the force distribution plate and/or between the force distribution plate and the container.

11. A method according to one of the claims 1 to 10, **characterised in that** the diameter of the blind vias lies between 3 µm and 20 µm and the depth between 10 µm and 150 µm, wherein the aspect ratio is greater than 5, preferably greater than 8.

12. A method according to one of the claims 1 to 11, **characterised in that** Cu baths or Co baths, including common alloy additives such as B and W are used for the electroless metallisation.

13. A method according to one of the claims 1 to 8, **characterised in that** on seeding the substrate which is immersed into a seeding fluid received in a vessel, force impacts are likewise applied onto the vessel, in a manner such that they act in the direction of the blind vias.

14. A method according to one of the preceding claims, with the exception of claim 8, **characterised in that** several substrates are arranged over one another, wherein the substrates are held by a flexible holder, preferably a bag-like net.

15. A method according to claim 14, without reference to claim 5, **characterised in that** the substrates are arranged over one another, obliquely with respect to a container base of a container receiving the metallisation bath.

## Revendications

1. Procédé de réalisation de métallisations dans des trous d'interconnexion borgnes, qui sont aménagés notamment dans un substrat constitué d'un matériau cassant pour la construction de circuits intégrés micro-électroniques tridimensionnels, chez lequel le substrat est soit lui-même actif au niveau catalytique avec les trous d'interconnexion borgnes, soit est ensemencé avec un matériau actif jouant un rôle catalytique, et ensuite est métallisé par dépôt sans courant au moins partiellement dans un bain de métallisation contenant un liquide de bain,
**caractérisé en ce que**
des sollicitations mécaniques sont appliquées sur le bain de métallisation avec le substrat de telle manière que l'accélération respectivement générée par celles-ci agit en vue de l'ouverture des trous d'interconnexion borgnes et pour l'amélioration du transport de liquide dans les trous d'interconnexion borgnes, et mène également à l'évacuation de bulles de gaz.

2. Procédé selon la revendication 1, **caractérisé en ce que** les sollicitations sont appliquées de telle manière qu'elles mènent à une accélération du liquide du bain et font que le substrat avec un mouvement vers le haut du aux sollicitations, où l'accélération s'élève à au moins 10 m/sec², de préférence entre 15 et 50 m/sec² pour une durée d'accélération d'au maximum 1/100 sec et où le mouvement de retrait vers le bas de retour vers la position de départ par contre est accéléré de manière maximale jusqu'à l'accélération dans une chute libre.

3. Procédé selon la revendication 1 ou la revendication 2, **caractérisé en ce que** les sollicitations sont exécutées de manière continue ou par des coups groupés se succédant de manière continue, où de 1 à 10 coups par 10 secondes sont appliqués et les intervalles entre les groupes des sollicitations continues s'élèvent à au moins 10 fois les intervalles entre les sollicitations continues.

4. Procédé selon l'une des revendications 1 à 3, **caractérisé en ce que** les sollicitations sont appliquées sur le bain de métallisation sous la forme de coups élastiques.

5. Procédé selon l'une des revendications 1 à 4, **caractérisé en ce que** les sollicitations sont appliquées en direction des axes des trous d'interconnexion borgnes.

6. Procédé selon l'une des revendications 1 à 5, **caractérisé en ce que** le substrat est disposé dans un récipient réceptionnant le bain de métallisation sans liaison avec les parois de récipient, où les ouvertures des trous d'interconnexions borgnes se situent à l'opposé du fond de récipient et que les sollicitations sont appliquées sur le fond de récipient.

7. Procédé selon la revendication 6, **caractérisé en ce que** les sollicitations sont appliquées par l'intermédiaire d'une plaque de répartition des charges disposée en dessous du fond de récipient pour une distribution de la force sur toute la surface sur le bain de métallisation.

8. Procédé selon l'une des revendications 1 à 7, **caractérisé en ce que** le substrat est disposé dans un récipient contenant le bain de métallisation dans un état libre sensiblement parallèle au fond de récipient, où une lamelle ou une couche de liquide est formée entre le substrat et le fond de récipient pour la transmission de la force.

9. Procédé selon l'une des revendications 1 à 8, **caractérisé en ce que** les sollicitations sont appliquées au moyen d'un ensemble de chaudronnerie ou au moyen d'une pluralité de générateurs d'impulsions, comme des éléments piézo-électriques.

10. Procédé selon la revendication 9, **caractérisé en ce que**, lors de l'utilisation d'un ensemble de chaudronnerie, un matériau élastique est disposé entre le marteau et le récipient, ou éventuellement entre le marteau et la plaque de répartition des charges, et/ou entre la plaque de répartition des charges et le récipient, pour l'optimisation de l'accélération et de la durée de l'accélération.

11. Procédé selon l'une des revendications 1 à 10, **caractérisé en ce que** le diamètre des trous d'interconnexion borgnes se situe entre 3 µm et 20 µm et la profondeur entre 10 µm et 150 µm, où le rapport d'aspect est supérieur à 5, de préférence, supérieur à 8.

12. Procédé selon l'une des revendications 1 à 11, **caractérisé en ce que**, pour la métallisation sans courant de bains de Cu ou de Co, des ajouts d'alliages usuels sont employés de manière complémentaires, comme de B ou de W.

13. Procédé selon l'une des revendications 1 à 8, **caractérisé en ce que**, lors de l'ensemencement du substrat, le substrat étant immergé dans un liquide d'ensemencement réceptionné dans un récipient, des sollicitations sont également appliquées sur le récipient de telle manière qu'elles agissent sur l'ouverture des trous d'interconnexion borgnes.

14. Procédé selon l'une des revendications précédentes, à l'exception de la revendication 8, **caractérisé en ce que** plusieurs substrats sont disposés les uns sur les autres, où les substrats sont maintenus par un support souple, de préférence une sorte de tuyau en mailles.

15. Procédé selon la revendication 14, sans nouvelle référence à la revendication 5, **caractérisé en ce que** les substrats sont disposés les uns sur les autres inclinés par rapport à un fond de récipient d'un récipient contenant le bain de métallisation.
